# FASCICULE DE BREVET EUROPEEN

(11) **EP 3 214 203 B1**
(45) Date de publication et mention de la délivrance du brevet: **03.03.2021**
(21) Numéro de dépôt: 17157713.3
(22) Date de dépôt: 23.02.2017
(51) Int. Cl.: C23C 16/30, C23C 30/00

(54) **ELEMENT OPTIQUE TRANSPARENT POUR VEHICULE AUTOMIBILE**
TRANSPARENTES OPTISCHES ELEMENT FÜR KRAFTFAHRZEUG
TRANSPARENT OPTICAL ELEMENT FOR MOTOR VEHICLE

(30) Priorité: 01.03.2016 FR 1651716
(43) Date de publication de la demande: 06.09.2017
(73) Titulaire: Valeo Vision, 93012 Bobigny Cedex (FR)
(72) Inventeur: REVOL, Damien, 75018 PARIS (FR); AUBERT, Nicolas, 95150 TAVERNY (FR); BRASSIER, Marc, 94170 LE PERREUX SUR MARNE (FR)

(56) Documents cités:
- EP-A1- 0 455 551
- DE-B3-102012 112 780
- DE-C1- 10 012 516

## Description

La présente invention se rapporte à un élément optique transparent pour véhicule automobile comprenant au moins une couche à base de silicium, de titane, d'oxygène et d'azote.

Elle s'applique typiquement, mais non exclusivement, aux domaines de l'optique, notamment aux articles optiques du type vitrage automobile, tels que par exemple des dispositifs d'éclairage et/ou de signalisation lumineuse de véhicule automobile.

Les dispositifs d'éclairage de véhicule automobile, tels que par exemple un projecteur avant ou un feu arrière, comprennent typiquement un boitier et une glace transparente de fermeture du boitier. Cette glace transparente de fermeture peut présenter des propriétés anti-buée ou anti-condensation, grâce notamment à un vernis acrylique appliqué sur la face intérieure de la glace transparente de fermeture.

Cependant, le vernis appliqué présente un pouvoir d'absorption d'eau relativement important, ce qui induit un stockage d'eau à l'intérieur du dispositif d'éclairage. De ce fait, lors de l'évaporation de cette eau résiduelle, des zones de saturation d'eau ou de coulure d'eau, bien connues sous l'anglicisme « water sagging », peuvent se former à la surface de la glace transparente de fermeture. Ces zones de saturation d'eau, à de très basses températures, peuvent endommager le vernis et le micro-fissurer, dégradant ainsi ses propriétés anti-buée et rendant ainsi la glace transparente de fermeture impropre à son utilisation en configuration opérationnelle.

Enfin, l'épaisseur de ce vernis appliqué sur la surface intérieure de la glace transparente de fermeture peut ne pas être homogène sur l'ensemble de la surface traitée, et de ce fait, les propriétés anti-buée s'en trouvent affectées.

Le document EP 0 455 551 A1 décrit quant à lui un élément optique transparent pour véhicule automobile comprenant au moins une première couche transparente en un matériau polymère, e.g. un substrat polycarbonate, et au moins une deuxième couche transparente anti-UV comprenant du silicium, du carbone, de l'oxygène et de l'azote, e.g. une couche de formule SiCxNyOzHt.

Le but de la présente invention est de pallier les inconvénients des techniques de l'art antérieur en proposant un élément optique transparent pour véhicule automobile limitant de façon significative, voire évitant, les zones de coulure d'eau tout en garantissant de bonnes propriétés anti-buée dans le temps, notamment pendant une durée d'au moins deux ans.

La présente invention a pour objet un élément optique transparent pour véhicule automobile comprenant au moins une première couche transparente en un matériau polymère, caractérisé en ce que l'élément optique comprend en outre au moins une deuxième couche transparente comprenant au moins du silicium, du titane, de l'oxygène et de d'azote, et telle que définie dans la revendication 1.

Grâce à l'invention, l'élément optique, en configuration opérationnelle, présente une activité photocatalytique optimisée, tout en garantissant de très bonnes propriétés anti-buée, et en limitant significativement, voire évitant, la formation de coulures d'eau. En outre, l'élément optique de l'invention est facile à fabriquer et garantit des propriétés homogènes sur l'ensemble de la surface traitée par la deuxième couche.

L'activité photocatalytique permet de réaliser des réactions chimiques en présence de lumière. Son principe repose sur la génération de paires électron-trou dans un matériau semi-conducteur par absorption de photons dont l'énergie est au moins égale à la largeur de bande interdite du matériau. Ces porteurs de charge vont ensuite réagir avec des espèces chimiques en surface du matériau par photocatalyse oxydante.

Plus particulièrement, l'activité photocatalytique de l'élément optique de l'invention peut être réalisée à des longueurs d'onde λ allant de 380 nm à 780 nm (lumière visible), et de préférence à des longueurs d'onde λ supérieures ou égales à 400 nm.

Dans la présente invention, on entend par « élément transparent ou couche transparente », un élément ou une couche transmettant la lumière par réfraction et au travers duquel/de laquelle les objets sont visibles avec plus ou moins de netteté. Plus particulièrement, c'est un élément ou une couche à travers lequel/laquelle une image est observée sans perte significative de contraste : l'interposition dudit élément transparent ou de ladite couche transparente entre une image et un observateur de celle-ci ne réduit pas significativement la qualité de l'image. En effet, au sens de l'invention, un élément transparent peut transmettre au moins une partie de la lumière incidente (ou rayon lumineux incident) avec très peu voire sans dispersion. De préférence, la transmission lumineuse, notamment la transmission de la lumière visible, à travers l'élément transparent ou couche transparente est d'au moins 87%. La transmission lumineuse est la quantité de lumière que laisse passer l'élément transparent ou couche transparente à partir d'un rayon lumineux incident.

Une fois la deuxième couche transparente déposée sur la première couche, la couleur de la première couche est visible au travers de la deuxième couche. La transparence de la deuxième couche est telle que la couleur de la première couche, perçue à travers la deuxième couche est sensiblement la même que la couleur de la première couche. La même couleur signifie que la variation des paramètres L*a*b selon la méthode CIELab respecte notamment les valeurs suivantes ΔL ≤ 2,0, Δa ≤ 1,0, Δb ≤ 1,0, le paramètre L* définissant la clarté, les paramètres a* et b* définissant la chromaticité.

La deuxième couche de l'invention peut comprendre de 30% à 90% en poids de silicium, et de préférence de 40 % à 70% en poids de silicium, par rapport au poids total de la deuxième couche.

La deuxième couche de l'invention peut comprendre de 1 % à 70% en poids de titane, et de préférence de 5% à 30% en poids de titane, par rapport au poids total de la deuxième couche.

La deuxième couche de l'invention peut comprendre de 40 % à 60% en poids d'oxygène, et de préférence de 45% à 55% en poids d'oxygène, par rapport au poids total de la deuxième couche.

La deuxième couche de l'invention peut comprendre de 0.0001 % à 5% en poids d'azote, et de préférence de 0,02 % à 0,1 % en poids d'azote, par rapport au poids total de la deuxième couche.

La détermination des différents pourcentages en poids indiqués ci-dessus peut être classiquement réalisée par spectroscopie d'analyse élémentaire par exemple XPS (Spectroscopie de Photoélectrons X). L'analyse de la structure est réalisée par MEB/EDS (Microspcope Electronique à Balayage avec sonde pour spectroscopie à dispersion d'énergie).

### La deuxième couche

La deuxième couche de l'invention peut comprendre :
- un ou plusieurs groupement(s) silicium-oxygène (Si-O),
- un ou plusieurs groupement(s) titane-oxygène (Ti-O), et
- un ou plusieurs groupement(s) titane-azote (Ti-N).

Dans la présente invention, on entend par :
- « groupement silicium-oxygène », un groupement comprenant au moins un atome de silicium lié de façon covalente à un atome d'oxygène (Si-O) ;
- « groupement titane-oxygène », un groupement comprenant au moins un atome de titane lié de façon covalente à un atome d'oxygène (Ti-O) ; et
- « groupement titane-azote », un groupement comprenant au moins un atome de titane lié de façon covalente à un atome d'azote (Ti-N).

Dans un mode de réalisation particulier de l'invention, la deuxième couche peut comprendre un dérivé azoté de dioxyde de titane, et plus particulièrement un dérivé de dioxyde de titane dopé à l'azote. De préférence, le dérivé azoté de dioxyde de titane a pour formule TiO₂₋ₓNₓ avec 0,001 < x < 1,00, de préférence avec 0,01 ≤ x ≤ 0,10, et plus préférentiellement avec x = 0,02.

Dans la présente invention, la deuxième couche peut être obtenue à partir d'au moins un précurseur PR1 comprenant de l'oxygène et du silicium, et d'au moins un précurseur PR2 comprenant de l'oxygène et du titane.

On entend par « précurseur » tout composé, pris seul ou en combinaison, permettant d'obtenir la deuxième couche.

Plus particulièrement, le précurseur PR1 peut être choisi parmi un silane hydrocarboné, un fluorosilane, un organo-silicate, un monomère de siloxane, le dioxyde de silicium (SiO₂), et un de leurs mélanges.

Le silane hydrocarboné peut être le tétraméthysilane (TMS).

Le fluorosilane peut être le triéthoxyfluorosilane (TEOF).

L'organo-silicate peut être choisi parmi l'orthosilicate de tétraéthyle (TEOS), le tétraméthyl orthosilicate (TMOS), et un de leurs mélanges.

Ledit monomère de siloxane peut être choisi par exemple parmi l'hexaméthyldisiloxane (HMDSO), le tétraméthyldisiloxane (TMDSO), l'octaméthylcyclotétrasiloxane (OMCTSO), et un de leurs mélanges.

Dans la présente invention, le précurseur PR2 peut être le titanium tétraisopropoxide (TTIP) ou un de ses dérivés, le bis(acétylacétonate) diisopropoxyde de titane (TIPO), l'orthotitanate de tetrabutyle (TBOT), l'orthotitanate de tétrapropyle (TPOT), le citratoperoxotitanate d'ammonium, le tetrakis (9H-carbazole-9-yl-ethyl-oxy) titanium (Ti(OeCarb)₄), le dioxyde de titane (TiO₂), et un de leurs mélanges.

On peut citer comme exemple de dérivés de TTIP :
- l'acétyle acétonate tris isopropoxyde de titane (TAATIP),
- le TTIP modifié par l'éthylène glycol (EGMT), ou
- le TTIP modifié par l'acide acétique (HOAc/TTIP ou C₂H₄O₂:TTIP).

Le dopant N peut être substitué en partie par au moins un des éléments non-métalliques suivants : le carbone (C), le phosphore (P), le fluor (F), le soufre (S), et/ou par au moins un des éléments métalliques suivants : le zinc (Zn), le cuivre (Cu), l'argent (Ag), le fer (Fe), le cobalt (Co). Un mélange de ces composés est possible pour réalisé un co-dopage par exemple en associant le fluor (F) avec l'azote (N) ou le carbone (C) avec l'azote (N).

La deuxième couche conforme à l'invention peut avoir une épaisseur d'au plus 100 nm, et de préférence une épaisseur allant de 30 à 85 nm.

Dans la présente invention, la deuxième couche peut être déposée directement sur la surface de la première couche. A ce titre, la deuxième couche est directement en contact physique avec la première couche.

Selon un autre mode de réalisation, la deuxième couche peut être déposée indirectement sur la surface de la première couche. A ce titre, une ou plusieurs couche(s) additionnelle(s) peuvent être intercalée(s) entre la première couche et la deuxième couche. Ainsi la deuxième couche n'est pas directement en contact physique avec la première couche.

Dans un mode de réalisation particulièrement préféré, la deuxième couche peut être une couche hydrophile.

Dans la présente invention, on entend par « hydrophile » un matériau ou une couche dont la surface présente un angle de contact (ou angle de goutte) strictement inférieur à 80°, et de préférence supérieur ou égal à 10°. On entend plus particulièrement par super hydrophile un matériau dont la surface présente un angle de contact inférieur à 10°.

La mesure de l'angle de contact rend compte de l'aptitude d'un liquide à s'étaler sur une surface par mouillabilité. La méthode consiste à mesurer l'angle de la tangente du profil d'une goutte déposée sur le matériau ou la couche, avec la surface du matériau ou de la couche.

Cet angle de contact est typiquement mesuré à l'aide d'un goniomètre, à 25°C, en utilisant de l'eau distillée.

### La première couche

L'élément optique de l'invention comprend une ou plusieurs première(s) couche(s) transparente(s) en un matériau polymère, ou en d'autres termes il comprend une ou plusieurs première(s) couche(s) transparente(s) comprenant un matériau polymère.

La première couche peut comprendre au moins 50% en poids de matériau polymère, de préférence au moins 60% en poids de matériau polymère, et de façon particulièrement préférée au moins 80% en poids de matériau polymère, par rapport au poids total de la première couche.

Dans un mode de réalisation particulier, la première couche transparente peut comprendre uniquement ledit matériau polymère.

Le matériau polymère de la première couche peut comprendre au moins un polymère P choisi parmi le polycarbonate (PC), le polycarbonate modifié haute température (PC-HT), le polyméthacrylate de méthyle (PMMA), le polymetacryl imide (PMMI), le cyclo olefine polymer (COP), le cyclo olefin copolymer (COC), le polysulfone (PSU), le polyarylate (PAR), le polyamide transparent (PA), et un de leurs mélanges.

Le matériau polymère peut comprendre au moins 50% en poids du polymère P, de préférence au moins 60% en poids du polymère P, et de façon particulièrement préférée au moins 80% en poids du polymère P, par rapport au poids total du matériau polymère.

Dans un mode de réalisation particulier, le matériau polymère peut comprendre uniquement un ou plusieurs polymère(s) P.

La première couche conforme à l'invention peut avoir une épaisseur d'au moins 1,0 mm, et de préférence d'au moins 2,5 mm. Elle peut en outre avoir une épaisseur d'au plus 5 mm, et de préférence d'au plus 3,5 mm.

### L'élément optique

L'élément optique transparent de l'invention peut être du type vitrage automobile, et peut faire partie par exemple d'un dispositif lumineux du type dispositif d'éclairage et/ou de signalisation lumineuse de véhicule automobile.

Plus particulièrement, l'élément optique transparent peut être une glace de fermeture d'un dispositif lumineux, telle que la glace d'un projecteur avant ou la glace d'un feu arrière de véhicule automobile.

La glace de fermeture d'un dispositif lumineux peut comprendre une face intérieure et une face extérieure, la face extérieure étant celle qui est directement en contact avec l'environnement extérieur ou en d'autres termes la couche directement exposée aux agressions extérieures.

Dans un mode de réalisation particulièrement préféré, la première couche de l'élément optique de l'invention peut être la face extérieure de ladite glace de fermeture, dans le dispositif lumineux.

En outre, la deuxième couche peut être la face intérieure de ladite glace de fermeture, dans le dispositif lumineux.

Un autre objet de l'invention concerne un dispositif lumineux de véhicule automobile comprenant l'élément optique transparent selon l'invention.

En particulier, le dispositif de l'invention peut comprendre un boîtier formant un volume dans lequel peut être logée une source lumineuse et/ou un module lumineux, l'élément optique venant fermer ledit boîtier.

### Le procédé de fabrication de l'élément optique

Un procédé de fabrication de l'élément optique selon l'invention est caractérisé en ce que la deuxième couche transparente peut être formée par au moins un procédé choisi parmi le flammage, un dépôt chimique en phase vapeur, un dépôt physique en phase vapeur, et un dépôt d'une couche atomique sous basse pression.

L'élément optique de l'invention est facile à fabriquer et garantit des propriétés homogènes sur l'ensemble de la surface traitée par la deuxième couche.

Selon un premier mode de réalisation, la deuxième couche transparente peut être formée par flammage.

Le procédé de flammage consiste à exposer à une flamme la surface à traiter.

La flamme de ce procédé est typiquement une flamme formée par le mélange d'au moins un combustible et d'au moins un comburant (i.e. mélange combustible/comburant), ce type de technique étant bien connue de l'homme du métier.

Le procédé de flammage peut être, par exemple, du type « one-step flame/spray pyrolysis » (FSP).

Selon un deuxième mode de réalisation du procédé, a deuxième couche peut être formée par dépôt chimique en phase vapeur (CVD : « Chemical Vapor Deposition »), assisté notamment par plasma.

Selon une première variante du deuxième mode de réalisation, le dépôt chimique assisté par plasma peut être le procédé bien connu sous l'anglicisme « Plasma-Enhanced Chemical Vapor Déposition » (PECVD) pour désigner des procédés dits « hors équilibre ». Ce type de dépôt est réalisé sous vide, plus précisément sous basse pression (de l'ordre de 1 à 10 Pa soit 10⁻² à 10⁻¹ mbar).

Selon une deuxième variante du deuxième mode de réalisation, le dépôt chimique assisté par plasma peut être réalisé sous pression atmosphérique (APCVD). On parle alors de plasma à pression atmosphérique ou plasma « froid » dits « hors équilibre ».

On peut également citer d'autres types de procédés CVD, tels que par exemple le dépôt CVD assisté laser (LECVD) ou le dépôt CVD à partir d'oxyde(s) métallique(s) (MOCVD : « Métal Organic CVD », PP-MOCVD : « Pulse Pressure MOCVD »).

Selon un troisième mode de réalisation, le dépôt peut être effectué par dépôt physique en phase vapeur (PVD : « Physical Vapor Déposition »), et plus particulièrement par pulvérisation cathodique (également désigné par « sputtering ») en mode séquencé ou bien simultané.

Selon une première variante du troisième mode de réalisation, le dépôt peut être réalisé par pulvérisation cathodique réalisée en courant continu (« DC sputtering »), plus particulièrement par pulvérisation cathodique magnétron, à partir d'une cible de silicium et d'une cible de titane, en introduisant les gaz réactifs nécessaires (O₂ et N₂ par exemple).

Selon une deuxième variante du troisième mode de réalisation, le dépôt peut être réalisé par pulvérisation cathodique réalisée en courant alternatif (« AC sputtering ») moyenne ou radio fréquence à partir de cibles d'oxydes SiO₂ et TiO₂, avec introduction contrôlée par un débitmètre massique d'azote (N₂) lors du dépôt de la couche de TiO₂.

Selon d'autres variantes, le dépôt par pulvérisation cathodique peut être effectué en mode continu ou en mode pulsé.

Selon un quatrième mode de réalisation, le dépôt peut être réalisée par dépôt d'une couche atomique sous basse pression (ALD : « Atomic Layer Déposition ») en utilisant par exemple le TTIP et l'eau comme précurseurs.

D'autres modes de réalisation sont possibles par dépôts liquides en utilisant les mêmes précurseurs : «spin coating » (enrobage par centrifugation) ou «dip coating » (enrobage par trempage) qui nécessitent généralement un traitement thermique pour obtenir une structure de couche ayant les fonctionnalités nécessaires. Cependant, ces procédés ne sont pas compatibles avec les substrats thermoplastiques comme ceux formant la première couche.

Le procédé privilégié mais non unique est le dépôt par plasma atmosphérique (deuxième variante du deuxième mode de réalisation).

Dans ce procédé, les valeurs des débits des différents composants peuvent varier dans les limites suivantes :
- Précurseur PR1 : de 0,001 mlₛ/min à 10 lₛ/min ;
- Précurseur PR2 : de 0,01 mlₛ/min à 10 lₛ/min ;
- Dopant (azote ou mélange azoté) : de 0,1 mlₛ/min à 100 lₛ/min ;
- Gaz porteur oxydant (air ou oxygène) : de 1 mlₛ/min à 100 lₛ/min.

L'unité mlₛ/min signifie « millilitre standard par minute », et l'unité lₛ/min signifie « litre standard par minute », les conditions standards correspondant à une pression de 1013 mbar et à une température de 20°C.

D'autres caractéristiques et avantages de la présente invention apparaîtront à la lumière de la description d'exemples non limitatifs.

### Exemple

### Fabrication d'un élément optique conforme à l'invention

Le support utilisé en tant que première couche est un polycarbonate (PC) transparent, commercialisé par la société KUDEB sous la référence M.AL2447. Ce polycarbonate est sous forme d'une plaque rectangulaire avec les dimensions suivantes : 15 cm de longueur, 10,5 cm de largeur, et 3,2 mm d'épaisseur.

Les composés suivants ont été utilisés :
- PR1 : TEOS commercialisé par la société Sigma Aldrich sous la référence 86578 pureté ≥ 99% (CAS No. 78-10-4) ;
- PR2 : TTIP commercialisé par la société Sigma Aldrich sous la référence 87560 pureté ≥ 97% (CAS No. 546-68-9) ; et
- L'azote utilisé comme gaz porteur et dopant est commercialisé par la société Air Liquide sous la référence Alphagaz 1 Azote (CAS No. 7727-37-9).

Le procédé par plasma atmosphérique est mis en œuvre.

La puissance du générateur alimentant l'électrode est de 1000 Watts. Le débit massique du précurseur PR1 TEOS est de 1,5 mlₛ/min et le débit du précurseur PR2 TTIP est de 0,1 mlₛ/min, le débit de gaz dopant (N₂) est de 50 mlₛ/min, le débit d'air (O₂) est de 100 mLm. La distance entre la buse et le substrat est de 15 mm. La vitesse de dépôt est fixée à 100 mm seconde.

On obtient ainsi une première couche de PC comportant une deuxième couche de silicium, titane, oxygène et azote déposée directement sur sa surface, la deuxième couche ayant une épaisseur d'environ 85 nm.

Cette deuxième couche est caractérisée par une structure de type « core/shell » (noyau/enveloppe), dans laquelle au moins une particule de SiO₂ est recouverte par une enveloppe de nanoparticules de TiO₂₋ₓNₓ distribuées à la surface de ladite particule de SiO₂. Le ratio du diamètre moyen des nanoparticules de TiO₂₋ₓNₓ par rapport au diamètre moyen des particules de SiO₂ est d'environ 1:10. Cette structure a été caractérisée par MEB/EDS (Microscope émectectronique à balayage équipé d'une sonde).

Différents tests ont été réalisés sur la pièce ainsi traitée :

### 1-Evaluation de l'effet anti condensation :

Les échantillons sont placés au-dessus d'une bouilloire contenant de l'eau pendant une minute puis posés à plat et laissés 10 minutes à 60°C. Les échantillons sont ensuite laissés durant 3 jours à température ambiante (23°C) en atmosphère non confinée. Le test d'exposition à la bouilloire est répété (20 fois). L'observation montre qu'il n'y a pas de condensation visible dans la zone traitée selon l'invention alors qu'elle est très visible, avec formation de gouttelettes d'eau condensée, sur un échantillon d'une pièce non traitée selon l'invention.

### 2-Cycles climatiques

Les échantillons sont placés :
- durant 16 heures à 85°C dans une atmosphère dont l'humidité relative est de 95%, puis
- durant 3 heures à -20°C dans une atmosphère sèche (humidité relative égale à 0%), et enfin
- durant 6 heures à 85°C dans une atmosphère dont l'humidité relative est inférieure à 30%.

Le cycle est répété 5 fois. Aucune altération ou modification de l'aspect du traitement n'est observée.

### 3-Anale de contact

L'angle de contact avec l'eau distillée est inférieur à 10°, montrant le niveau élevé d'hydrophilie de la deuxième couche réalisée selon l'invention (« super hydrophilie »). Cette caractéristique est conservée après les tests 1 et 2.

## Revendications

1. Elément optique transparent pour véhicule automobile comprenant au moins une première couche transparente en un matériau polymère, **caractérisé en ce que** l'élément optique comprend en outre au moins une deuxième couche transparente comprenant au moins du silicium, du titane, de l'oxygène et de l'azote, ladite deuxième couche présentant une structure de type « core/shell » (noyau/enveloppe), dans laquelle au moins une particule de SiO₂ est recouverte par une enveloppe de nanoparticules de TiO₂₋ₓNₓ distribuées à la surface de ladite particule de SiO₂, le ratio du diamètre moyen des nanoparticules de TiO₂₋ₓNₓ par rapport au diamètre moyen des particules de SiO₂ étant d'environ 1:10.

2. Elément optique selon la revendication 1, **caractérisé en ce que** la deuxième couche comprend :
- un ou plusieurs groupement(s) silicium-oxygène (Si-O),
- un ou plusieurs groupement(s) titane-oxygène (Ti-O), et
- un ou plusieurs groupement(s) titane-azote (Ti-N).

3. Elément optique selon la revendication 1 ou 2, **caractérisé en ce que** la deuxième couche comprend un dérivé azoté de dioxyde de titane de formule TiO₂₋ₓNₓ avec 0,001 < x < 1,00.

4. Elément optique selon la revendication 3, **caractérisé en ce que** 0,01 ≤ x ≤ 0,10.

5. Elément optique selon l'une quelconque des revendications précédentes, **caractérisé en ce que** la deuxième couche a une épaisseur d'au plus 100 nm.

6. Elément optique selon l'une quelconque des revendications précédentes, **caractérisé en ce que** la deuxième couche est une couche hydrophile.

7. Elément optique selon l'une quelconque des revendications précédentes, **caractérisé en ce que** la deuxième couche est directement en contact physique avec la première couche.

8. Elément optique selon l'une quelconque des revendications précédentes, **caractérisé en ce que** le matériau polymère de la première couche comprend au moins un polymère P choisi parmi le polycarbonate (PC), le polycarbonate modifié haute température (PC-HT), le polyméthacrylate de méthyle (PMMA), le polymetacryl Imide (PMMI), le cyclo olefine polymer (COP), le cyclo olefin copolymer (COC), le polysulfone (PSU), le polyarylate (PAR), le polyamide transparent (PA), et un de leurs mélanges.

9. Elément optique selon l'une quelconque des revendications précédentes, **caractérisé en ce qu'**il est une glace de fermeture d'un dispositif lumineux.

10. Elément optique selon la revendication précédente, **caractérisé en ce que** la glace de fermeture d'un dispositif lumineux comprend une face intérieure et une face extérieure, la première couche étant la face extérieure de la glace de fermeture.

11. Dispositif lumineux de véhicule automobile comprenant l'élément optique transparent selon l'une quelconque des revendications précédentes.

## Patentansprüche

1. Transparentes optisches Element für Kraftfahrzeuge, das mindestens eine erste transparente Schicht aus einem Polymermaterial umfasst, **dadurch gekennzeichnet, dass** das optische Element darüber hinaus mindestens eine zweite transparente Schicht umfasst, die mindestens Silicium, Titan, Sauerstoff und Stickstoff umfasst, wobei die zweite Schicht eine Struktur vom Typs "Core/Shell" (Kern/Hülle) aufweist, wobei mindestens ein SiO₂-Partikel von einer Hülle aus TiO₂₋ₓNₓ-Nanopartikeln bedeckt ist, welche auf der Oberfläche des SiO₂-Partikels verteilt sind, wobei das Verhältnis zwischen dem mittleren Durchmesser der TiO₂₋ₓNₓ-Nanopartikel und dem mittleren Durchmesser der SiO₂-Partikel ungefähr 1:10 beträgt.

2. Optisches Element nach Anspruch 1, **dadurch gekennzeichnet, dass** die zweite Schicht Folgendes umfasst:
- eine oder mehrere Silicium-Sauerstoff-Gruppe(n) (Si-O),
- eine oder mehrere Titan-Sauerstoff-Gruppe(n) (Ti-O) und
- eine oder mehrere Titan-Stickstoff-Gruppe(n) (Ti-N) .

3. Optisches Element nach Anspruch 1 oder 2, **dadurch gekennzeichnet, dass** die zweite Schicht ein stickstoffhaltiges Derivat von Titandioxid mit der Formel TiO₂₋ₓNₓ umfasst, wobei 0,001 < x < 1,00.

4. Optisches Element nach Anspruch 3, **dadurch gekennzeichnet, dass** 0,01 ≤ x ≤ 0,10.

5. Optisches Element nach einem beliebigen der vorhergehenden Ansprüche, **dadurch gekennzeichnet, dass** die zweite Schicht eine Dicke von höchstens 100 nm hat.

6. Optisches Element nach einem beliebigen der vorhergehenden Ansprüche, **dadurch gekennzeichnet, dass** die zweite Schicht eine hydrophile Schicht ist.

7. Optisches Element nach einem beliebigen der vorhergehenden Ansprüche, **dadurch gekennzeichnet, dass** die zweite Schicht unmittelbar in physischem Kontakt mit der ersten Schicht steht.

8. Optisches Element nach einem beliebigen der vorhergehenden Ansprüche, **dadurch gekennzeichnet, dass** das Polymermaterial der ersten Schicht mindestens ein Polymer P umfasst, das aus Polycarbonat (PC), hochtemperaturmodifiziertem Polycarbonat (PC-HT), Polymethylmethacrylat (PMMA), Polymethacrylimid (PMMI), Cycloolefinpolymer (COP), Cycloolefincopolymer (COC), Polysulfon (PSU), Polyarylat (PAR), transparentem Polyamid (PA) und deren Mischungen ausgewählt ist.

9. Optisches Element nach einem beliebigen der vorhergehenden Ansprüche, **dadurch gekennzeichnet, dass** es sich um eine Streuscheibe einer Leuchtvorrichtung handelt.

10. Optisches Element nach dem vorhergehenden Anspruch, **dadurch gekennzeichnet, dass** die Streuscheibe einer Leuchtvorrichtung eine Innenseite und eine Außenseite umfasst, wobei die erste Schicht der Außenseite der Streuscheibe entspricht.

11. Kraftfahrzeug-Leuchtvorrichtung, welche das transparente optische Element nach einem beliebigen der vorhergehenden Ansprüche umfasst.

## Claims

1. Transparent optical element for a motor vehicle comprising at least one first transparent layer of a polymer material, **characterized in that** the optical element further comprises at least one second transparent layer comprising at least silicon, titanium, oxygen and nitrogen, said second layer showing a structure of "core/shell" type, in which at least one particle of SiO₂ is covered by a shell of nanoparticles of TiO₂₋ₓNₓ distributed on the surface of said particle of SiO₂, the ratio of the mean diameter of the nanoparticles of TiO₂₋ₓNₓ to the mean diameter of the particles of SiO₂ is around 1:10..

2. Optical element according to claim 1, **characterized in that** the second layer comprises:
- one or more silicon-oxygen (Si-O) groups,
- one or more titanium-oxygen (Ti-O) groups, and
- one or more titanium-nitrogen (Ti-N) groups.

3. Optical element according to claim 1 or 2, **characterized in that** the second layer comprises a nitrogen derivative of titanium dioxide of formula TiO₂₋ₓNₓ with 0.001 < x < 1.00.

4. Optical element according to claim 3, **characterized in that** 0.01 ≤ x ≤ 0.10.

5. Optical element according to any one of the preceding claims, **characterized in that** the second layer has a thickness of at most 100 nm.

6. Optical element according to any one of the preceding claims, **characterized in that** the second layer is a hydrophilic layer.

7. Optical element according to any one of the preceding claims, **characterized in that** the second layer is directly in physical contact with the first layer.

8. Optical element according to any one of the preceding claims, **characterized in that** the polymer material of the first layer comprises at least one polymer P chosen from among polycarbonate (PC), high temperature modified polycarbonate (PC-HT), polymethyl methacrylate (PMMA), polymethacrylimide (PMMI), cyclo-olefin polymer (COP), cyclo-olefin copolymer (COC), polysulfone (PSU), polyarylate (PAR), transparent polyamide (PA), or mixtures thereof.

9. Optical element according to any one of the preceding claims, **characterized in that** it is a closure outer lens of a lighting device.

10. Optical element according to the preceding claim, **characterized in that** the closure outer lens of a lighting device comprises an interior face and an exterior face, the first layer being the exterior face of the closure outer lens.

11. Lighting device of a motor vehicle, comprising the transparent optical element according to any one of the preceding claims.
